Europäisches Patentamt

(19) European Patent Office

Office européen des brevets

(11) Publication number : **0 445 488 B1**

(12) **EUROPEAN PATENT SPECIFICATION**

(45) Date of publication of patent specification :
01.06.94 Bulletin 94/22

(21) Application number : **90810179.3**

(22) Date of filing : **08.03.90**

(51) Int. Cl.⁵ : **H01S 3/25, H01S 3/085,
G11B 7/125, H04B 10/00**

(54) **Semiconductor laser diode arrangement.**

(43) Date of publication of application :
**11.09.91 Bulletin 91/37**

(45) Publication of the grant of the patent :
**01.06.94 Bulletin 94/22**

(84) Designated Contracting States :
**DE FR GB IT**

(56) References cited :
**GB-A- 2 169 134
US-A- 4 428 647
US-A- 4 718 070
US-A- 4 807 238
APPLIED PHYSICS LETTERS, vol. 51, no. 15,
October 1987, pages 1138-1140, New York, US;
J.P. DONNELLY et al.: "Monolithic two-dimensional surface-emitting arrays of GaAs/AlGaAs diode lasers"**

(73) Proprietor : **International Business Machines
Corporation
Old Orchard Road
Armonk, N.Y. 10504 (US)**

(72) Inventor : **Voegeli, Otto, Dr.
13465 Sycamore Ave
Morgan Hill, CA 95037 (US)**

(74) Representative : **Barth, Carl Otto
International Business Machines Corp.
Zurich Research Laboratory
Intellectual Property Department
Säumerstrasse 4
CH-8803 Rüschlikon (CH)**

## Description

TECHNICAL FIELD

The invention concerns a laser diode arrangement with an epitaxially grown layered semiconductor structure in which an array of laser diodes and a plurality of integrated reflectors, one for each beam emitted by the array, are formed. The reflectors create an array of virtual sources with lateral distances therebetween that differ from the physical spacing of the laser diodes. More particularly, the virtual sources may be more closely spaced than the laser diodes and can even be concentrated in a single spot. A single lens can be used to project the array of virtual sources.

BACKGROUND OF THE INVENTION

Semiconductor laser diodes have found applications in a wide variety of information handling systems because of their compact size and because their technology is compatible with that of associated electronic circuitry and other electro-optical elements like, e.g., mirrors. They are being used in areas such as data communication, optical storage and optical beam printing.

Efforts aiming at improved performance in applications requiring more than one light source have led to the design of integrated laser arrays capable of emitting a plurality of closely spaced laser beams. In general, they are employed to replace slower serial operations by faster parallel processing, e.g., byte-processing instead of bit-by-bit processing, or in document scanning and printing.

A wide variety of laser array structures have been described, some of the publications being listed here :
- Article "Experimental and Analytic Studies of Coupled Multiple Stripe Diode Lasers" by D.R.Scifres et al (IEEE Journal of Quantum Electronics, Vol.QE-15, No.9, September 1979, pp 917-922).
- U.S. Patent 4,069,463 "Injection Laser Array" (issued January 1978).
- Europeam Patent Application 0 226 445, "Laser Array" (published June 24, 1987).
- European Patent Application 0 301 818, "Semiconductor Laser Array Device" (published February 1, 1989).
- European Patent Application 0 301 846, "Semiconductor Laser Array Apparatus" (published February 1, 1989).

Despite the progress made in recent years in developing processes to minimize device dimensions, a further reduction in the spacing between individual beams is still highly desirable for a number of high resolution applications. One approach that has been pursued is the use of optical systems to bring the laser beams closer together. However, the use of individual lens systems for each beam make such arrangements prohibitively complex and expensive and, in addition, for devices requiring feature dimensions in the order of microns, optical systems are at their physical limits. The laser arrangement described herein below points in a new direction.

Besides the efforts to arrive at closely spaced beams, there have been developments aiming at the design of surface emitting lasers wherein beams emitted in a plane parallel to the wafer surface on which the laser structure is epitaxially grown, are reflected at an integrated mirror to exit the device perpendicular to the wafer surface, mainly in order to facilitate packaging. Such arrangements have, e.g., been disclosed in
- U.S.Patent 3,996,492, "Two-Dimensional Integrated Injection Laser Array" (issued December 7, 1976).
- U.S.Patent 3,996,528, "Folded Cavity Injection Laser" (issued December 7, 1976).
- U.S.Patent Application 264 422, "Integrated Laser Arrays and Support Circuits" (filed October 31, 1988).
- IBM Technical Disclosure Bulletin, Article "Vertically Emitting Laser with Integrated NAM Deflector" (Vol. 32, No.3B, August 1989, pp 498 - 499).

Another approach to obtain surface emitting laser diodes is described in an Article "Surface Emitting Laser Diode with bent Waveguide", by M.Ogura et al (Appl. Phys. Lett. 50(12), 23 March 1987, pp 705 - 707). There, a bent double heterostructure fabricated on a grooved substrate is used instead of a deflecting mirror.

However, to our knowledge, no suggestion has yet been made to make use of the optical elements, required to achieve the desired "surface emitting", to provide virtual sources that are closer spaced than the corresponding beam sources and that can be projected using simple optical means.

With regard to the optical principle on which the herein described laser diode arrangement is based, there exists some similarity with the so-called "Fresnel's mirror" arrangement where light from a point source is incident on two plane mirrors mutually inclined at a small angle. Reflection at the mirrors gives raise to two virtual images. A description can be found in the handbook "Principles of Optics", Max Born & Emil Wolf, Pergamon Press, 6th Edition, p.262. This reference, however, does not in any way suggest any potential technical application of the described optical principle.

## SUMMARY OF THE INVENTION

It is the main object of the present invention to provide a laser diode arrangement in which a plurality of laser beam sources is transferred into a contracted or even coincident collection of virtual sources that can be projected onto a desired processing plane using simple optical means.

Another object is to provide a "surface emitting" integrated laser array structure from which the emitted laser beams exit in a direction essentially perpendicular to the surface of the wafer on which the structure is formed.

A further main object is to provide a method allowing the fabrication of the proposed integrated, surface emitting, reduced beam separation laser diode arrangement using a conventional unidirectional process in connection with proper masking segment geometries.

The invention as claimed in claim 1 is intended to meet these objectives and to remedy the deficiencies of known laser diode arrangements. In the inventive structure this is accomplished in that, for each of a plurality of laser beams emitted from a laser array, a tilted, individually oriented and positioned reflector is provided. These reflectors produce an array of virtual sources, the distances between these virtual sources being different from the distances between the corresponding beams (or real sources).

Using a single lens, the array of virtual sources can then be projected onto a desired plane. Most important will be embodiments in which the virtual sources are brought closer together or where they even coincide.

Claim 9 is related to a method of fabricating an array of reflectors integrated with an array of lined-up laser diodes.

The group of required reflectors, one for each beam, can be fabricated in a single directional dry-etch process using a mask whose segments (together with the common angle of the directional etch) properly determine the individual positions and the orientations of the tilted reflecting surfaces.

The main advantage offered by the invention is that the proposed structure can serve as a device transfering a plurality of laser beam sources into closer spaced, contracted laser sources which may even coincide. A few examples of applications where the inventive laser diode arrangment may be advantageously used are :

- Band-recording when spacing between tracks is smaller than the smallest obtainable spacing between adjacent lasers in a laser array; contracted virtual sources allow parallel recording on adjacent tracks.
- Gradual laser degradation depends on laser power; it can be reduced by operating several lasers with coincident virtual sources at a fractional power.
- Laser reliability may be vastly improved through redundancy; this can be obtained with coincident virtual sources, employed either sequentially or in combination.
- Power density in an imaged spot obtainable with a single laser diode is limited mainly because of catastrophic failure at the laser mirrors; the limit can be raised using coincident virtual sources.
- Short coherence length is important in some communications applications; this length can be shortened by combining the outputs of coincident virtual sources.

## DESCRIPTION OF THE DRAWINGS

One way of implementing the invention is described in detail below with reference to drawings which illustrate a specific embodiment and in which

**Fig. 1**    is a schematic view of a state of the art integrated "surface emitting" laser diode/reflector structure. (PRIOR ART).

**Fig. 2**    is a schematic illustration of the main elements of the inventive diode laser arrangement (used to explain the underlying concept).

**Fig. 3**    is a schematic illustration of the principle of the laser array/reflector arrangement and the key process parameters for the fabrication of the required individual reflectors.

**Fig. 4 (A,B & C)**    shows, schematically and largely simplified, top views of different reflector arrangements.

**Fig. 5**    is a perspective view of an embodiment of an integrated laser array/reflector arrangement designed in accordance with the present invention.

## DETAILED DESCRIPTION

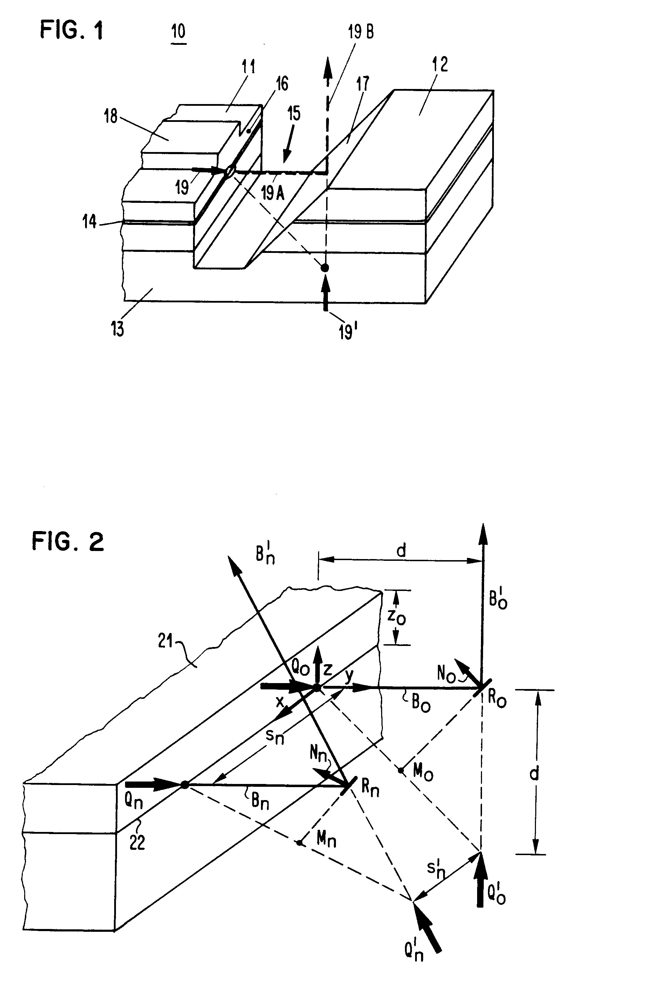

Before describing an embodiment of the inventive laser diode array in greater detail, the tilted reflector concept, applied in the structure to arrive at a surface emitting laser device, will be outlined with the aid of Fig.1.

Fig.1 is a perspective view of a known surface emitting laser structure 10 of which only the main elements

3

are shown. These are the laser diode 11 and the integrated 45 ° reflector 12. Both are formed in a stack of layers that are epitaxially grown on a GaAs substrate 13, the stack including at least the active layer 14 sandwiched between cladding layers. For simplicity reasons, only the active layer is indicated in the figure. The drawing shows the structure after completion of the etch process forming the groove 15 that provides the laser mirror facet 16 and the 45 ° reflecting surface 17. Omitted in the drawing are the metallization layers providing for the elctrical contacts to the completed device.

When the device is activated by applying proper operating voltages, a light beam 19 A is emitted. In the drawing, the light mode region of the laser is shown as a small ellipse centering around the active layer 14 and laterally defined by the stripe ridge 18. Arrow 19 represents the "real" source of the emitted beam 19 A which impinges onto the 45° surface 17. Here it is deflected making the laser "surface emitting", i.e., the output beam 19 B is in a direction essentially perpendicular to the substrate surface. Beam 19 B can be considered as being emitted without deflection from a virtual source 19'.

The purpose of the invention is to apply the tilted reflector concept to an array of integrated lasers and to simultaneously reduce the separation between the individual lasers of the array to an apparent (or virtual) smaller spacing thereby meeting the demand for multiple beam sources with spacings between the sources smaller than the smallest separation at which lasers can be fabricated and operated. The invention allows to transform a collection of real sources into a contracted or even coincident collection of virtual sources which can than be projected, using a single lens, to provide the required reduced-scale light pattern.

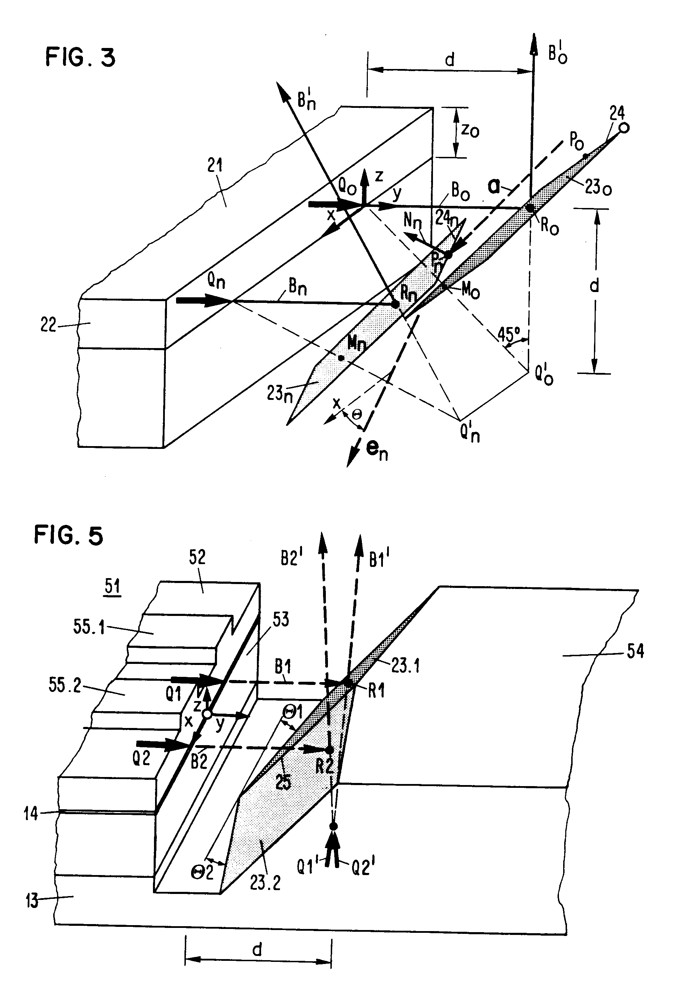

The principle will now be described with reference to figures 2 and 3. Fig.2 schematically illustrates a laser array structure 21 (similar in structure to the laser 11 of Fig.1), with two light sources $Q_o$ and $Q_n$, emitting beams $B_o$ and $B_n$, respectively. These "real" sources are formed by respective waveguides along the y-direction, the front mirror facets being in the x-z plane. It is, however, noted that, conceptually, the front mirrors do not have to be co-planar.

Beam $B_o$, proceeding in the y-z plane, is reflected at reflector $R_o$ and projected upwardly. The reflector surface is tilted 45°, its "normal" (perpendicular to the reflecting surface) is shown as arrow $N_o$. The virtual source $Q_o'$ of the beam is at the position indicated in the drawing.

The second source $Q_n$, representing any other source in the array, emits a beam $B_n$ from the array at a point that is separated from $Q_o$ by a distance $s_n$. Its beam $B_n$ is intersected by the reflector $R_n$.

The position of the respective virtual source $Q_n'$ is determined by the orientation and position of the reflector $R_n$. As explained above, it is the goal to achieve a virtual source $Q_n'$ located at a distance $s_n'$ from $Q_o'$ that is different from the separation $s_n$ of the respective real sources $Q_o$ and $Q_n$. In the extreme case, $s_n' = 0$, i.e., the virtual sources coincide and the respective separated real sources are projected onto a single spot.

The requirements and conditions for properly orienting and positioning any reflector $R_n$ are now developed. For beam $B_o$, the real ($Q_o$) and the virtual ($Q_o'$) sources lie in the y-z plane. If the exit beam $B_o'$ is to be perpendicular to the plane of the active layer 22 of the laser diode array (or to the wafer surface), i.e., to the x-y plane, $R_o$ must be parallel to the x-axis and tilted 45 °. It is placed at a distance d (determined by the far/near field beam pattern and other technology constraints) from the front mirror plane of the array. With this, the virtual source $Q_o'$ lies in the y-z plane, namely at the x,y,z -coordinates : (0,d,-d).

As can be seen from Fig.2, the reflector $R_o$ is (1) oriented with its normal $N_o$ parallel to the line $Q_oQ_o'$ connecting $Q_o$ and $Q_o'$, and it is (2) positioned with the reflector plane passing through the midpoint $M_o$ of this connecting line. These rules not only apply to source $Q_o$ and its assosciated reflector $R_o$ and the resulting virtual source $Q_o'$ but to all other sources formed in the same laser array such as $Q_n$ and the respective reflectors ($R_n$) and virtual sources ($Q_n'$).

As will become apparent further below, it is in many situations desirable or even necessary, that all virtual sources ($Q_o'$, $Q_n'$ and others) be lined-up in the x-direction. From this, another condition for the positioning of any virtual source $Q_n'$ emerges : it needs to be formed at the coordinates ($s_n'$, d, -d), with sn' being determined by the separation reduction factor $s_n' / s_n$ to be achieved.

It follows : When $Q_n$ is at the coordinates ($s_n$,0,0), then, to obtain the virtual source $Q_n'$ at coordinates ($s_n'$,d,-d), the reflector $R_n$ needs to be oriented such that its normal $N_n$ is parallel to the connecting line $Q_nQ_n'$. Furthermore, the reflector $R_n$ has to be positioned such that it bisects the connecting line at its midpoint $M_n$. The direction of the reflected beam $B_n'$ is generally upward but, as illustrated in Fig. 2, it is tilted from the normal to the x-y plane (or the wafer surface).

The reflected upward beams $B_o'$ and $B_n'$ (and possibly others), seemingly stemming from their respective virtual sources $Q_o'$, $Q_n'$, etc., can then be collected by a single lens (not shown) that provides, in a predetermined plane, a reduced-scale projection of the virtual source pattern $Q_o',Q_n'$.

When the reflectors $R_o$, $R_n$ (and possibly others) are oriented and positioned so as to combine all virtual sources in one point (with $s_n' = 0$), the lens provides a projection of the virtual sources concentrated in one point where their light energy is added.

It should be noted that the virtual sources do not necessarily have to be positioned on a straight line. For certain applications, some arc may be preferable since it may either compensate for some lens aberrations or allow the use of simpler lenses. Such configurations of virtual sources can be obtained by properly adjusting the y-positions of the lasers and/or the reflectors.

Next, it will be illustrated how the inventive structure can, in principle, be fabricated. Reference is made to Fig.3 showing, schematically, an arrangement similar to that of Fig.2. It comprises the two real sources $Q_o$ and $Q_n$, emitting beams $B_o$ and $B_n$ from waveguides formed around active layer 22 in array structure 21, and the respective reflectors $R_o$ and $R_n$. The array structure 21 can be produced and designed using conventional laser diode techniques and, as will be shown below, the differently oriented and positioned reflectors $R_o$ and $R_n$ can also be fabricated using standard processes.

With conventional fabrication methods, two adjustable parameters are available. There is the direction of processing (as exemplified by the angle of incidence in directional dry-etching processes), and there is the boundary of processing (as determined by a lithographically defined mask pattern).

In Fig.3, beams $B_o$ and $B_n$, from real sources $Q_o$ and $Q_n$, strike the tilted reflector surfaces $23_o$ and $23_n$ at points $R_o$ and $R_n$, from where beams $B_o'$ and $B_n'$ are reflected in a generally upward direction as illustrated. In the drawing, the beam axes are shown as being reflected at the center points $R_o$ and $R_n$ of the tilted plane surfaces represented by the parallelograms $23_o$ and $23_n$. Obviously, the beam divergence requires a certain surface area rather than just the reflecting points $R_o$ and $R_n$. For simplicity reasons, however, only the beam axes are shown in the drawings.

Since it is desired or required to produce the reflecting surfaces $23_o$ , $23_n$ and possibly others, in a single process, the tilt angle with respect to the x-z plane of all reflectors is determined by the processing vector $\vec{a}$ , e.g., the etch-direction in a directional etch process. In Fig.3, a tilt angle of 45 ° has been assumed. The reflecting surfaces $23_o$ and $23_n$ are, furthermore, defined by their respective masking edges $24_o$ and $24_n$, lying in the same plane as the top surface of array 21, i.e., in the x-y plane at $z=z_o$ ($z_o$ being the thickness of the layers above the active layer 22, as indicated).

Following is a general consideration applicable for any reflecting surface $23_n$ and its beam-axis reflecting point $R_n$ . Surface $23_n$ is determined by the processing vector $\vec{a}$ (45 ° as noted above) and by the masking edge $24_n$ which, in turn, is determined by vector $\vec{e}_n$ = (cos $\Theta_n$ , sin $\Theta_n$, 0), $\Theta$ being the azimuthal orientation with respect to the x-direction. Vectors $\vec{a}$ and $\vec{e}_n$ determine the orientation and the position of plane $23_n$ and thus the plane normal $N_n = \vec{a} \times \vec{e}_n$.

The rules that have been developed in connection with Fig.2 require

(1) that the normal $N_n$ of the reflector $23_n$ be parallel to line $Q_nQ_n'$, and

(2) that the reflector surface $23_n$ has to pass through the mid-point $M_n$ of line $Q_nQ_n'$.

Applying these rules, one obtains the equations

$$\vec{R}_n \;=\; \vec{a} \times \vec{e}_n \;=\; \overline{Q_nQ_n}' \qquad\qquad [1]$$

and for the $M_n$ coordinates

$$M_n \;=\; \left( \frac{s_n + s_n'}{2} ,\; \frac{d}{2} ,\; -\frac{d}{2} \right) \qquad\qquad [2]$$

For the chosen 45 ° etch direction, one has $\vec{a}$ = (0,-1,-1), and furthermore

$$\vec{a} \;\times\; \vec{e}_n \;=\; (0,-1,-1) \;\times\; (\cos \Theta_n, \sin \Theta_n, 0)$$
$$=\; (\sin \Theta_n, -\cos \Theta_n, \cos \Theta_n)$$

With this, equation (1) simplifies to

$$(\sin \Theta_n, -\cos \Theta_n, \cos \Theta_n) \quad = \quad Q_n Q_n'$$
$$= \quad (s_n, 0, 0) \quad - \quad (s_n', d, -d)$$
$$= \quad ((s_n - s_n'), -d, d)$$

From this equation one obtains :

$$\tan \Theta_n = \frac{s_n - s_n'}{d} \quad [3]$$

$\Theta_n$ determines the orientation of the mask edge 24n whereas the position of this edge is defined by the mid-point Pn of the edge having coordinates

$$P_n = \left( \frac{s_n + s_n'}{2}, \quad d + z_o, \quad z_o \right) \quad [4]$$

It follows for the assumed processing vector $\vec{a}$ (with a processing angle in the y-z plane of 45 °) that the y-coordinate of all reflection points $R_n$ equals d, i.e., for an array 21 with front mirrors in the x-y plane, the distance between the mirror facet and the reflection points equals d for all beams.

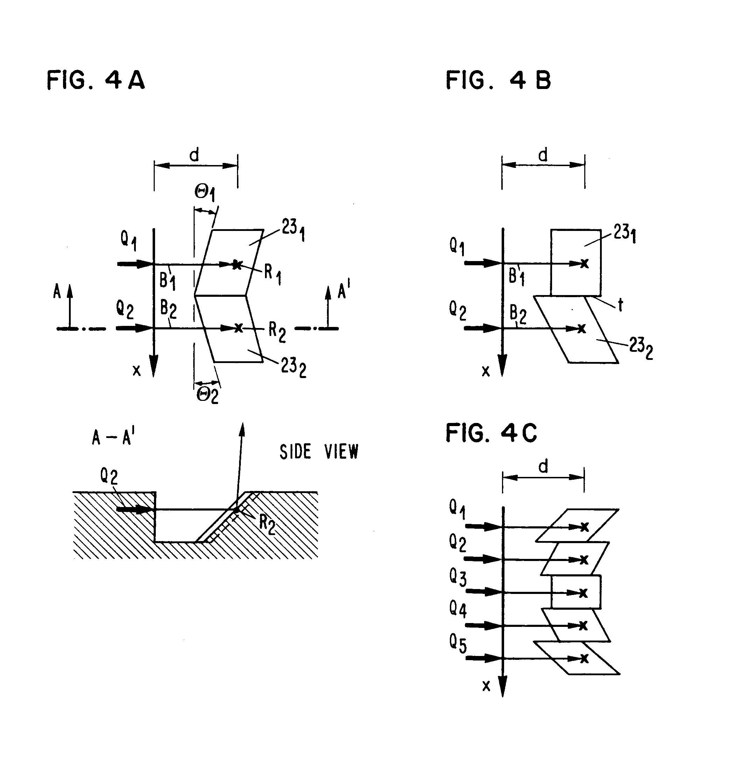

Fig.4 schematically illustrates how the reflecting surfaces 23n can, in principle, be positioned with respect to varying numbers of real sources to meet the requirement $Q_n R_n = d$.

Fig.4A is a top-view of the arrangement chosen for the embodiment of the invention that will be described in more detail below. Two beams, $B_1$ and $B_2$, emitted from sources $Q_1$ and $Q_2$, strike the associated reflector surfaces $23_1$ and $23_2$ at $R_1$ and $R_2$, respectively. The reflector surfaces form angles $\Theta_1$ and $\Theta_2$ with the x-axis. The respective side-view, representing a cross-section A-A' through the arrangement, is shown to ease understanding.

Fig.4B represents another 2-beam embodiment. However, in contrast to the arrangement of Fig.4A, one of the reflecting surfaces (struck by beam B1) is oriented parallel to the x-axis. As a consequence, a "step" t between the two reflector surfaces $23_1$ and $23_2$ is required to meet the $Q_n R_n = d$ condition.

Fig.4C illustrates a 5-beam array, each beam with its associated reflecting surface. Again, steps are required between neighbouring reflecting surfaces.

Fig.5 is an illustration of an embodiment of a laser diode arrangement 51 designed in accordance with the present invention. The structure comprises a laser array structure 52 emitting beams B1 and B2 from sources Q1 and Q2, respectively.

Basically, the arrangement 51 corresponds to the structures considered in connection with figures 2, 3 and 4A. The reflecting surfaces 23.1 and 23.2 are oriented as in Fig.4A, i.e., both surfaces form angles ($\Theta$1 and $\Theta$2) with the x-axis, the tilted reflecting surfaces intersecting at x = 0. With this configuration, there are no steps required (as in the embodiments shown schematically in figures 4B and 4C) to meet the condition

$$Q1R1 = Q2R2 = d$$

The operation of the device is as described above. When applying proper operating voltages, the laser structure 52 emits beams B1 and B2; they strike the respective reflecting surfaces 23.1 and 23.2 at points R1 and R2. Reflected beams B1' and B2' exit the arrangement in an upward direction with their axes symmetrically tilted from the wafer normal since the surfaces 23.1 and 23.2 form angles $\Theta$1 and $\Theta$2 with the x-axis.

A collecting lens (not shown in the drawing), arranged above the arrangement, is used to project the virtual sources Q1' and Q2' onto a desired processing plane.

If the angles $\Theta$1 and $\Theta$2 are chosen as illustrated in Fig.5, virtual sources Q1' and Q2' are projected onto in single point. This is obtained when $s_n' = 0$, in which case equation (3) simplifies to

$$\tan \Theta 1 = \tan \Theta 2 = \frac{s_n}{d} \quad [5]$$

Now, the fabrication process for the laser diode structure of Fig.5 will be outlined.

The epitaxially grown multi-layer stack which forms the basis for the laser array 52 and the reflector structure 54 can be essentially the same and fabricated using the same process as that decribed in an article by C.Harder et al, entitled "High-Power Ridge-Waveguide AlGaAs GRINSCH Laser Diode" (published in Electronics Letters, 25th September 1986, Vol.22, No.20, pp 1081-82). The sequence of steps for producing the stack of layers (not all of them are specifically indicated in Fig.5) is as follows :

The layers are grown on an n+ -doped GaAs substrate 13 by, e.g., molecular beam epitaxy (MBE). First, an n-doped GaAs buffer layer is grown on the substrate. Next is a lower, n-type cladding layer ($Al_{0.45}Ga_{0.55}As$). The core of the laser consists of a graded n-type region (0.2 µm $Al_{0.45}Ga_{0.55}As$ graded towards $Al_{0.18}Ga_{0.82}As$), an undoped active region 14 forming a quantum well (7 nm GaAs), and a graded p-type region (0.2 µm $Al_{0.18}Ga_{0.82}As$ graded towards $Al_{0.45}Ga_{0.55}$ As). Next is the top p-type cladding layer ($Al_{0.45}Ga_{0.55}As$), followed by a p+ GaAs contact layer with a doping density that is high enough for a titanium-platinum-gold electrode to make good ohmic contact. Another ohmic contact, at the bottom side of the n-type substrate 13, is obtained by alloying germanium, gold and nickel.

In the present embodiment, ridges 55.1 and 55.2, about 4 µm wide and 20 µm apart, provide for lateral waveguiding for the two waveguides serving as real sources Q1 and Q2. The ridges are formed on top of the structure prior to depositing the metal contact electrodes by first applying a photoresist mask to define the ridges, followed by etching 1 to 2 µm of the exposed top layers - etching being stopped 0.2 µm above the graded-index part of the top cladding layer. This is then followed by depositing 100 nm $SiO_2$ and subsequent lift-off, removing the $SiO_2$ on the ridges.

The groove, one of its sidewalls serving as the laser mirror facet 53, the other sidewall providing the deflecting surfaces 23.1 and 23.2 at the reflector structure 54, is then etched using a mask and an etching method basically corresponding to those described in detail in pending European Patent Application 88.810613.5, filed on September 12, 1988. The vertical etching and the 45° etching is done using directional ion beam techniques by appropriately tilting the wafer relative to the ion beam in a 2-step process.

The 45 ° deflecting surfaces are coated with a dielectric layer having a high reflectivity whereby the front facet output power of the laser diodes is emitted upwardly, almost perpendicular to the surface of the wafer.

Typical dimensions of the structure in Fig.5 are : The length of the laser structure 52 is between 300 and 1000 µm, that of the reflector structure 54 being uncritical (unless simultaneously used for other purposes such as beam monitoring). The lateral distance between the sources Q1 and Q2 is in the order of 20 µm and equals the distance d between the mirror facet 53 and the reflecting points R1 and R2. The angles $\Theta 1$ and $\Theta 2$ between the reflecting surface planes 23.1 and 23.2 and the x-direction are derived from equation (5) :

$$\tan \Theta 1 \ = \ - \ \frac{\frac{1}{2}d}{d} \qquad \text{and} \qquad \tan \Theta 2 \ = \ + \ \frac{\frac{1}{2}d}{d}$$

From this, the absolute value of the angles is obtained to be 26.5 °.

## Claims

1. A semiconductor laser diode arrangement comprising
   - an epitaxially grown, layered structure (52) disposed on a semiconductor substrate (13), with an ar-ray of laterally spaced ($s_n$) waveguides, each forming the source (Q1, Q2) for a laser beam (B1, B2) emitted in a direction substantially parallel to the surface of said semiconductor substrate, and
   - integrated, tilted and individually oriented reflectors (R1, R2), one for each of said beams (B1, B2), positioned in the beam paths so as to create an array of virtual sources (Q1', Q2'), the laterel distance ($s_n'$) between said virtual sources (Q1', Q2') being different from the distances ($s_n$) between the cor-responding sources (Q1, Q2).

2. An arrangement as in claim 1, furthermore comprising an optical lens system for collecting the reflected beams (B1', B2') and for forming an image of said virtual sources.

3. An arrangement as in claim 1, wherein the light mode regions of the sources (Q1, Q2) are lined-up in a common mirror facet (53), and wherein the virtual sources (Q1', Q2') are positioned on a straight line parallel to said lined-up light mode regions.

4. An arrangement as in claim 1, wherein the distance (d) between the mirror facet that terminates the waveguides of all sources (Q1, Q2) of the array and the reflectors (R1, R2) is the same for all source-reflector pairs.

5. An arrangement as in claim 1, wherein the reflected beams (B1', B2') proceed in a direction that is essentially perpendicular to the substrate surface so as to provide a surface emitting device.

6. An arrangement as in claim 1, wherein the distances ($s_n'$) between said virtual sources (Q1', Q2') are smaller than those between the corresponding sources (Q1, Q2).

7. An arrangement as in claim 6, wherein said virtual sources (Q1', Q2') coincide.

8. An arrangement as in any of the preceding claims, wherein an even number of sources (Q1, Q2) is provided, and wherein each of the reflectors (23.1, 23.2) associated therewith forms an angle unequal zero ($\Theta$1, $\Theta$2) with the mirror facets terminating the waveguides of the array of sources (Q1, Q2).

9. A method for fabricating an array of reflectors integrated with an array of lined-up laser diodes formed in an epitaxially grown layered structure disposed on a semiconductor substrate (13) as an array of laterally spaced waveguides each forming a source ($Q_o$, $Q_n$) emitting a laser beam ($B_o$, $B_n$) in a direction substantially parallel to the surface of said semiconductor substrate (13),
comprising the steps of
- providing a reflector structure (54) from which tilted, individually oriented reflectors ($23_o$, $23_n$), one for each of said laser diode beams ($B_o$, $B_n$), are to be formed,
- applying an etch-mask on the top of said reflector structure, patterned to have individual segments ($24_o$, $24_n$), one for each of said reflectors ($23_o$, $23_n$) to be formed, the positions and directions of which determine the positions and orientations of said reflectors, and
- etching said reflector structure (54), using a unidirectional dry-etch process, to form said array of reflectors ($23_o$, $23_n$), thereby providing, for each laser beam ($B_o$, $B_n$), an associated, individually oriented reflector deflecting said beam in a direction substantially perpendicular to the surface of said semiconductor substrate (13).

10. A method as in claim 9, wherein said individually oriented reflectors are positioned in the beam paths so as to create an array of virtual sources ($Q_o'$, $Q_n'$) positioned on a straight line parallel to the light mode regions of the lined-up laser diodes.

11. A method as in claim 9, wherein the distance (d) between the mirror facet that terminates the waveguides of all sources ($Q_o$, $Q_n$) of the array and the reflectors ($R_o$, $R_n$) is the same for all source-reflector pairs.

12. A method as in claim 9, wherein the distances ($s_n'$) between said virtual sources ($Q_o$, $Q_n$) are smaller than those between the corresponding sources ($Q_o$, $Q_n$).

13. A method as in claim 12, wherein said virtual sources ($Q_o$, $Q_n$) coincide.

**Patentansprüche**

1. Eine Halbleiterlaseranordnung, bestehend aus
- einer epitaxisch gebildeten, schichtförmig aufgebauten Struktur (52), die auf einem Halbleitersubstrat (13) angeordnet ist, mit einer Gruppierung seitlich voneinander getrennter ($s_n$) Wellenführungen, von denen jede die Quelle (Q1, Q2) für einen Laserstrahl (B1, B2) bildet, der in eine Richtung ausgesendet wird, die im wesentlichen parallel zur Oberfläche des genannten Halbleitersubstrats liegt, und
- integrierten, geneigten und einzeln ausgerichteten Reflektoren (R1, R2), wobei je einer einem der genannten Strahlen (B1, B2) zugeordnet ist, die sich in den Strahlenpfaden befinden, um eine Gruppierung aus virtuellen Quellen (Q1', Q2') zu bilden, wobei der seitliche Abstand ($s_n'$) zwischen den genannten virtuellen Quellen (Q1', Q2') anders ist als die Abstände ($s_n$) zwischen den entsprechenden Quellen (Q1, Q2).

2. Eine Anordnung gemäß Anspruch 1, des weiteren bestehend aus einem optischen Linsensystem zur Sammlung der reflektierten Strahlen (B1', B2') und zur Erzeugung eines Bildes anhand der genannten virtuellen Quellen.

3. Eine Anordnung gemäß Anspruch 1, in der die Lichtmodusbereiche der Quellen (Q1, Q2) in einer gewöhnlichen Spiegelfacette (53) aneinandergereiht sind, und in der die virtuellen Quellen (Q1', Q2') auf einer geraden Linie parallel zu den genannten aneinandergereihten Lichtmodusbereichen positioniert sind.

4. Eine Anordnung gemäß Anspruch 1, in der der Abstand (d) zwischen der Spiegelfacette, die die Wellenführungen aller Quellen (Q1, Q2) der Gruppierung beendet, und der Reflektoren (R1, R2) für alle Quellen-Reflektorpaare gleich ist.

5. Eine Anordnung gemäß Anspruch 1, in der die reflektierten Strahlen (B1', B2') in einer Richtung verlaufen, die im wesentlichen rechtwinklig zur Substratoberfläche ist, und eine oberflächenaussendende Anordnung bilden.

6. Eine Anordnung gemäß Anspruch 1, in der die Abstande ($s_n'$) zwischen den genannten virtuellen Quellen (Q1', Q2') kleiner sind als diejenigen zwischen den entsprechenden Quellen (Q1, Q2).

7. Eine Anordnung gemäß Anspruch 6, in der die genannten virtuellen Quellen (Q1', Q2') zusammenfallen.

8. Eine Anordnung gemäß jedem der vorhergehenden Ansprüche, in der eine gerade Anzahl an Quellen (Q1, Q2) bereitgestellt wird, und in der jeder der Reflektoren (23.1, 23.2), der mit diesen Quellen in Verbindung steht, mit den Spiegelfacetten, die die Wellenführungen der Gruppierung der Quellen (Q1, Q2) beenden, einen Winkel bildet, der ungleich Null ist ($\Theta 1$, $\Theta 2$).

9. Ein Verfahren zur Erzeugung einer Gruppierung von Reflektoren, die mit einer Gruppierung von aneinandergereihten Laserdioden integriert sind und zu einer durch epitaxisches Wachstum gebildeten Struktur geformt werden, die auf einem Halbleitersubstrat (13) als Gruppierung seitlich voneinander getrennter Wellenführungen angeordnet ist, von denen jede eine Quelle ($Q_o$, $Q_n$) bildet, die einen Laserstrahl ($B_o$, $B_n$) in eine Richtung aussendet, die im wesentlichen parallel zur Oberfläche des genannten Halbleitersubstrats (13) ist,
bestehend aus den Schritten
- zur Bereitstellung einer Reflektorstruktur (54), aus denen geneigte, einzeln ausgerichtete Reflektoren ($23_o$, $23_n$), von denen jeder für einen der genannten Laserdiodenstrahlen ($B_o$, $B_n$) bestimmt ist, gebildet werden sollen.
- zum Auftragen einer Ätzmarkierung auf der Oberseite der genannten Reflektorstruktur, die durch das Muster bedingt einzelne Segmente ($24_o$, $24_n$) aufweist, von denen jedes für einen der genannten zu bildenden Reflektoren ($23_o$, $23_n$) bestimmt ist, deren Positionen und Richtungen die Positionen und Ausrichtungen der genannten Reflektoren bestimmen, und
- zur Ätzung der genannten Reflektorstruktur (54) unter Einsatz eines einseitig gerichteten Trockenätzverfahrens zur Bildung der genannten Gruppierung von Reflektoren ($23_o$, $23_n$), wodurch für jeden Laserstrahl ($B_o$, $B_n$) ein dazugehöriger, einzeln ausgerichteter Reflektor bereitgestellt wird, der den genannten Strahl in eine Richtung ablenkt, die im wesentlichen rechtwinklig zur Oberfläche des genannten Halbleitersubstrats (13) ist.

10. Ein Verfahren gemäß Anspruch 9, bei dem die genannten einzeln ausgerichteten Reflektoren so in den Strahlenpfaden positioniert sind, daß sie eine Gruppierung virtueller Quellen ($Q_o'$, $Q_n'$) bilden, die auf einer geraden Linie positioniert sind, die parallel zu den Lichtmodusbereichen der aneinandergereihten Laserdioden verläuft.

11. Ein Verfahren gemäß Anspruch 9, bei dem der Abstand (d) zwischen der Spiegelfacette, die die Wellenführungen aller Quellen ($Q_o'$, $Q_n'$) der Gruppierung und der Reflektoren (Ro, Rn) beendet, für alle Quellen-Reflektor-Paare gleich ist.

12. Ein Verfahren gemäß Anspruch 9, wobei die Abstände ($s_n'$) zwischen den genannten virtuellen Quellen ($Q_o$, $Q_n$) kleiner sind als diejenigen zwischen den dazugehörigen Quellen ($Q_o$, $Q_n$).

13. Ein Verfahren gemäß Anspruch 12, bei dem die genannten virtuellen Quellen ($Q_o$, $Q_n$) zusammenfallen.


**Revendications**

1. Agencement à diode laser semiconductrice comprenant
- une structure (52) à couches à croissance épitaxiale disposée sur un substrat semiconducteur (13), avec un réseau de guides d'ondes espacés latéralement ($S_n$), formant chacun la source (Q1, Q2) pour un faisceau laser (B1, B2) émis dans une direction sensiblement parallèle à la surface dudit substrat semiconducteur, et

- des réflecteurs (R1, R2) intégrés, inclinés et orientés individuellement, à raison d'un pour chacun desdits faisceaux (B1, B2), placés dans les trajets des faisceaux de manière à créer un réseau de sources virtuelles (Q1', Q2'), la distance latérale ($S_n'$) entre lesdites sources virtuelles (Q1', Q2') étant différente des distances ($S_n$) entre les sources correspondantes (Q1, Q2).

2. Agencement selon la revendication 1, comprenant en outre un système à lentille optique pour rassembler les faisceaux réfléchis (B1', B2') et pour former une image desdites sources virtuelles.

3. Agencement selon la revendication 1, dans lequel les régions en mode de lumière des sources (Q1, Q2) sont alignées dans une facette (53) de miroir commun, et dans lequel les sources virtuelles (Q1', Q2') sont placées sur une ligne droite parallèle auxdites régions en mode de lumière alignées.

4. Agencement selon la revendication 1, dans lequel la distance (d) entre la facette du miroir qui termine les guides d'ondes de toutes les sources (Q1, Q2) du réseau et les réflecteurs (R1, R2) est identique pour toutes les paires source-réflecteur.

5. Agencement selon la revendication 1, dans lequel les faisceaux réfléchis (B1', B2') se propagent dans une direction qui est essentiellement perpendiculaire à la surface du substrat de manière à fournir un dispositif d'émission de surface.

6. Agencement selon la revendication 1, dans lequel les distances ($S_n'$) entre lesdites sources virtuelles (Q1', Q2') sont inférieures à celles entre les sources correspondantes (Q1, Q2).

7. Agencement selon la revendication 6, dans lequel lesdites sources virtuelles (Q1', Q2') coïncident.

8. Agencement selon l'une quelconque des revendications précédentes, dans lequel un nombre pair de sources (Q1, Q2) est prévu, et dans lequel chacun des réflecteurs (23.1, 23.2) qui leur est associé forme un angle non nul ($\Theta 1$, $\Theta 2$) avec les facettes du miroir terminant les guides d'ondes du réseau de sources (Q1, Q2).

9. Procédé de fabrication d'un réseau de réflecteurs intégré avec un réseau de diodes laser alignées formées dans une structure à couches à croissance épitaxiale disposée sur un substrat semiconducteur (13) comme un réseau de guides d'ondes espacés latéralement formant chacun une source ($Q_0$, $Q_n$) émettant un faisceau laser ($B_0$, $B_n$) dans une direction sensiblement parallèle à la surface dudit substrat semiconducteur (13).
comprenant les étapes suivantes
   - fourniture d'une structure de réflecteur (54) à partir de laquelle des réflecteurs ($23_o$, $23_n$) orientés individuellement, à raison d'un pour chacun desdits faisceaux à diode laser ($B_o$, $B_n$) doivent être formés,
   - application d'un masque d'attaque chimique au sommet de ladite structure de réflecteur, configuré pour avoir des segments individuels ($24_o$, $24_n$), à raison d'un pour chacun desdits réflecteurs ($23_o$, $23_n$) à former, dont les positions et les directions déterminent les positions et les orientations desdits réflecteurs et
   - attaque chimique de ladite structure de réflecteur (54), en utilisant un processus d'attaque à sec unidirectionnel, pour former ledit réseau de réflecteurs ($23_o$, $23_n$), afin de fournir, pour chaque faisceau laser ($B_o$, $B_n$), un réflecteur associé, orienté individuellement, déviant ledit faisceau dans une direction sensiblement perpendiculaire à la surface dudit substrat semiconducteur (13).

10. Procédé selon la revendication 9, dans lequel lesdits réflecteurs orientés individuellement sont positionnés dans les trajets de faisceaux de manière à créer un réseau de sources virtuelles ($Q_o'$, $Q_n'$) positionné sur une ligne droite parallèle aux régions en mode de lumière des diodes laser alignées.

11. Procédé selon la revendication 9, dans lequel la distance (d) entre la facette du miroir qui termine les guides d'ondes de toutes les sources ($Q_o$, $Q_n$) du réseau et les réflecteurs ($R_o$, $R_n$) est identique pour toutes les paires source-réflecteur.

12. Procédé selon la revendication 9, dans lequel les distances ($S_n'$) entre lesdites sources virtuelles ($Q_o$, $Q_n$) sont inférieures à celles entre les sources correspondantes ($Q_o$, $Q_n$).

13. Procédé selon la revendication 12, dans lequel lesdites sources virtuelles ($Q_o$, $Q_n$) coïncident.

FIG. 1          10

FIG. 2

FIG. 3

FIG. 5

FIG. 4 A

FIG. 4 B

FIG. 4 C